# EUROPÄISCHE PATENTSCHRIFT

(11) **EP 1 363 477 B1**
(45) Veröffentlichungstag und Bekanntmachung des Hinweises auf die Patenterteilung: **07.01.2015**
(21) Anmeldenummer: 03010029.1
(22) Anmeldetag: 02.05.2003
(51) Int. Cl.: H05B 37/03, H05B 33/08

(54) **Elektrische Schaltungsanordnung sowie Verfahren zur Überprüfung der Intaktheit eines Photodiodenarrays**
Electric circuit and method for monitoring the integrity of a Photodiode array
Circuit électrique ainsi qu 'une méthode pour vérifier le bon fonctionnement d' une matrice à diodes photoélectriques

(30) Priorität: 07.05.2002 DE 10220306
(43) Veröffentlichungstag der Anmeldung: 19.11.2003
(73) Patentinhaber: Leopold Kostal GmbH & Co. KG, 58507 Lüdenscheid (DE)
(72) Erfinder: Bläsing, Frank, 59457 Werl (DE); Schirp, Christian, 44866 Bochum (DE)

(56) Entgegenhaltungen:
- EP-A- 0 896 899
- DE-A1- 19 930 174
- US-A- 5 896 084
- US-A1- 2001 013 572

## Beschreibung

Die Erfindung betrifft eine elektrische Schaltungsanordnung sowie ein Verfahren zur Überprüfung der Intaktheit eines Photodiodenarrays sowie einer Leitungsverbindung zwischen dem Photodiodenarray und einem räumlich von diesem abgesetzten, zur Auswertung des Ausgangssignals desselben vorgesehenen Mikroprozessors, wobei der Ausgang des Photodiodenarrays im inaktiven, intakten Zustand hochohmig ist und im Fehlerfall über jeweils einen festgelegten Innenwiderstand mit Masse- oder Versorgungsspannungspotential verbunden ist.

Photodiodenarrays der betreffenden Art bestehen aus einer linearen oder flächigen Anordnung einer Vielzahl i. a. als Pixel bezeichneter, photosensitiver Elemente auf einem Halbleiterchip, wobei jedes dieser Pixel ein die auf demselben auftreffende Lichtmenge repräsentierendes analoges Ausgangssignal liefert. Sie werden für eine Vielzahl optischer Sensorzwecke eingesetzt, bei denen eine ortsaufgelöste Helligkeitsinformation benötigt wird. Die analogen Ausgangssignale der einzelnen Pixel werden dabei in der Regel nacheinander aus dem Chip herausgetaktet und einem Analog/Digital-Wandler-Eingang eines Mikroprozessors zugeführt, der diese in digitale Helligkeitswerte umwandelt, die in einem dem spezifischen Anwendungsfall entsprechenden Auswertealgorithmus weiterverarbeitet werden.

Ein möglicher Anwendungsfall insbesondere für ein zeilenförmiges Photodiodenarray ist z.B. ein optoelektronischer Drehwinkelsensor, wie er beispielsweise als Lenkwinkelsensor für Kraftfahrzeuge zum Einsatz kommt.

Ein solcher Sensor ist aus der DE 40 22 837 A1 bekannt. Der in diesem Dokument beschriebene Lenkwinkelsensor umfaßt eine elektronische Steuereinheit sowie eine Sensoreinheit, bestehend aus zwei parallel und mit Abstand zueinander angeordneten Elementen - einer Lichtquelle und einem Zeilensensor - sowie einer zwischen der Lichtquelle und dem Zeilensensor angeordneten Codescheibe, die drehfest mit der Lenkspindel verbunden ist. Als Zeilensensor dient hier eine CCD-Sensorzeile. Als Codierung ist bei dieser Codescheibe eine sich über 360° erstreckende, als Lichtschlitz ausgebildete archimedische Spirale vorgesehen. Über die Belichtung entsprechender Wandlerelemente des Zeilensensors bei einem bestimmten Lenkeinschlag kann Aufschluß über die tatsächliche Lenkwinkelstellung gewonnen werden. Die als Codierung eingesetzte archimedische Spirale ist kontinuierlich verlaufend ausgebildet, so daß diese als analoge Codierung angesprochen werden kann. Mit der gleichen Anordnung läßt sich aber auch ebensogut eine digitale Codierung auf der Codescheibe auslesen, die beispielsweise in Form eines Gray-Codes ausgeführt sein kann.

Dokument US2001013572 offenbart ein Verfahren und eine Vorrichtung zur Durchführung des Verfahrens zur Qualitätskontrolle für eine Photo, insbesondere ein Photodiodenarray, dessen Ausgangssignal abhängig von der Intensität des Eingangssignals durch elektromagnetische Wellen gebildet wird. Der Photo zu prüfenden Stimulationssignale empfängt, welche die Eingangssignale während der Stimulationssignalintensität der Stimulationssignale variiert wird. Die zugehörigen Ausgangssignale der Photo getestet werden gemessen und zur Auswertung aufgezeichnet. Der Photosensor empfängt vorzugsweise zumindest zwei unabhängig steuerbaren, übereinander angeordneten einzelnen Stimulationssignale mit individuellen Intensitäten. Die verschiedenen Stimulationssignalintensitäten der einzelnen Stimulationssignale werden mit Hilfe einer auf die Stimulation Signalquelle gekoppelt Steuerung gesetzt, und die Ausgangssignale des Photosensors gemessen und aufgezeichnet unter Verwendung eines Messdatenaufzeichnungseinheit.

Aus Bauraumgründen ist es bei derartigen Anwendungen oftmals erforderlich, die eigentliche Sensoreinheit, d.h. den Zeilensensor und die Lichtquelle räumlich getrennt von der zugehörigen elektronischen Steuer- und Auswerteeinheit anzuordnen. Dies macht eine mehr oder weniger lange Verbindungsleitung zwischen diesen Einheiten erforderlich, welche in Form von Steckkontakten, Folienleitern o.ä. ausgeführt sein kann. In jedem Falle stellt diese Verbindung jedoch eine Quelle zusätzlicher Fehler dar, welche z.B. in Form von Kontaktierungsproblemen oder Leitungsrissen auftreten können.

Gebräuchliche Photodiodenarrays bieten zwar die Möglichkeit über den Status des Ausgangssgnals eine direkte Diagnose des Bauelements selbst vorzunehmen, bei einer Leitungsunterbrechung liegt jedoch bei einer entfernt angeordneten Auswerteeinheit ein undefinierter Zustand vor.

Gegenüber diesem Stand der Technik bieten die erfindungsgemäße Schaltungsanordnung sowie das zugehörige Verfahren den Vorteil, jederzeit eine Aussage über den Zustand der Leitung und bei intakter Leitung zusätzlich über die Intaktheit des Photodiodenarrays zu ermöglichen.

Dies gelingt erfindunggemäß dadurch, daß der Ausgang des Photodiodenarrays über einen in räumlicher Nähe zu diesem angeordneten, ersten Prüfwiderstand mit Massepotential verbunden ist, und daß der zum Signal-Empfang vorgesehene Analog-Digital-Wandler-Eingang des Mikroprozessors über einen in räumlicher Nähe zu diesem angeordneten zweiten Prüfwiderstand mit einem wahlweise mit Masse- oder Versorgungsspannungs-potential verbindbaren Port-Ausgang des Mikroprozessors verbunden ist.

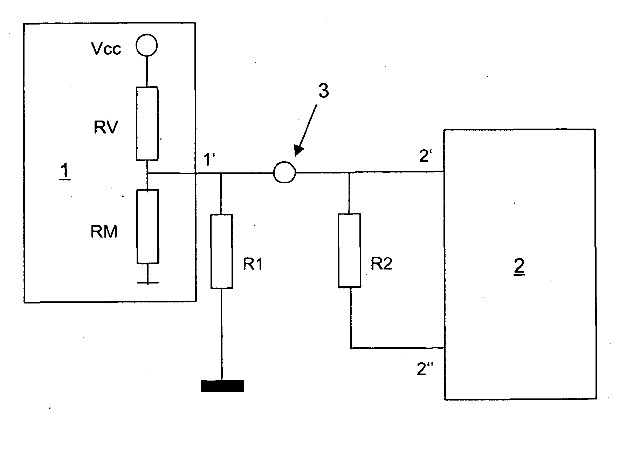

Diese Ausgestaltung ermöglicht durch gezieltes Verbinden des zweiten Prüfwiderstandes einmal mit Massepotential und dann mit Versorgungsspannungspotential die Erzeugung definierter Spannungszustände am Analog-Digital-Wandler-Eingang des Mikroprozessors, welche eine Aussage über den Leitungszustand sowie ggf. die Intaktheit des Photodiodenarrays zulassen.
Vorteilhafte Ausgestaltungen der Erfindung ergeben sich aus den Unteransprüchen sowie aus der nachfolgenden Beschreibung des in der Zeichnung als Blockschaltbild wiedergegebenen Ausführungsbeispiels.

Wie aus der Zeichnung zu erkennen, umfaßt die erfindungsgemäße Schaltungsanordnung einerseits das Photodiodenarray 1 und andererseits den zur Auswertung des Ausgangssignals desselben vorgesehenen Mikroprozessor 2. Diese beiden Einheiten befinden sich auf zwei verschiedenen Schaltungsträgern, welche über elektrisch leitende Verbindungsmittel 3 miteinander verbunden sind. Bei diesen Verbindungsmitteln 3 handelt es sich beispielsweise um eine Steckverbindung, welche die Leiterbahnen der beiden z.B. in einer zueinander senkrechten Ausrichtung angeordneten Schaltungsträger miteinander kontaktiert oder etwa eine mit Leiterbahnen versehene flexible Folie, welche die entsprechenden Potentiale miteinander verknüpft.
Das Photodiodenarray 1 enthält als integrale Bestandteile die beiden Innenwiderstände RV und RM über welche der Signalausgang 1' im Falle einer Fehlfunktion mit der Versorgungsspannung bzw. mit dem Massepotential verbunden ist. Beim intakten Photodiodenarray 1 ist der Ausgang 1' im inaktiven Zustand, d.h. also beispielsweise nach der Beendigung des Austaktens des analogen Ausgangssignals, hochohmig. Auf dem Schaltungsträger des Photodiodenarrays 1 ist zusätzlich ein erster Prüfwiderstand R1 angeordnet, über den der Ausgang 1' des Photodiodenarrays 1 mit Massepotential verbunden ist. Ein zweiter Prüfwiderstand R2 ist auf dem Schaltungsträger des Mikroprozessors 2 angeordnet, und verbindet den über die Leitungsverbindung 3 mit dem Ausgang 1' des Photodiodenarrays 1 verbundenen Analog-Digital-Wandler-Eingang 2' des Mikroprozesors 2 mit einem digitalen Port-Ausgang 2" desselben, welcher wahlweise mit dem Masse- oder mit dem Versorgungsspannungspotential verbindbar ist. Durch Verbinden des Port-Ausganges 2" und damit des zweiten Prüfwiderstandes R2 einmal mit Massepotential und dann mit Versorgungsspannungspotential werden im Zusammenhang mit dem ersten Prüfwiderstand R1 sowie dem Ausgangszustand des Photodiodenarrays 1 definierte Spannungszustände am Analog-Digital-Wandler-Eingang 2' des Mikroprozessors 2 erzeugt. Diese Spannungszustände lassen nach Maßgabe der folgenden Tabelle (aufgestellt für R1 = R2) eine Aussage über den Leitungszustand sowie ggf. die Intaktheit des Photodiodenarrays 1 zu.

| **Status** | **Port-Ausgang = Vcc** | **Port-Ausgang = Gnd** |
|---|---|---|
| Normale Verbindung, Zeile i.O. (=hochohmig) | Spannungsteiler R1 zu R2 | Beide R ziehen nach GND |
| | **→ Vcc/2** | → **Gnd** |
| Keine Verbindung, | R2 zieht nach VCC | R2 zieht nach Gnd |
| Zeile egal' | → **Vcc** | → **Gnd** |
| Normale Verbindung, | Spannungsteiler R2 zu R1∥RM | Zeile,R1,R2 ziehen zu Gnd |
| Zeile liegt mit RM an Gnd | → **Vcc/2 bis Gnd** | **→ Gnd** |
| Normale Verbindung, Zeile liegt mit RV an Vcc | Spannungsteiler R2∥RV zu R1 | Spannungsteiler RV zu R1∥R2 |
| | → **Vcc bis Vcc/2** | **→ Vcc bis > Gnd** |

## Patentansprüche

1. Elektrische Schaltungsanordnung zur Überprüfung der Intaktheit eines Photodiodenarrays (1) sowie einer Leitungsverbindung (3) zwischen dem Photodiodenarray (1) und einem räumlich von diesem abgesetzten, zur Auswertung des Ausgangssignals desselben vorgesehenen Mikroprozessor (2), wobei der Ausgang (1') des Photodiodenarrays (1) im inaktiven, intakten Zustand hochohmig ist und im Fehlerfall über jeweils einen festgelegten Innenwiderstand (RM, RV) mit Masse- bzw. Versorgungsspannungspotential verbunden ist, **dadurch gekennzeichnet, daß** der Ausgang (1') des Photodiodenarrays (1) über einen in räumlicher Nähe zu diesem angeordneten, ersten Prüfwiderstand (R1) mit Masse- oder Versorgungsspannungspotential verbunden ist, und daß der zum Signal-Empfang vorgesehene Analog-Digital-Wandler-Eingang (2') des Mikroprozessors (2) über einen in räumlicher Nähe zu diesem angeordneten zweiten Prüfwiderstand (R2) mit einem wahlweise mit Masse- oder Versorgungsspannungspotential verbindbaren Port-Ausgang (2") des Mikroprozessors (2) verbunden ist.

2. Elektrische Schaltungsanordnung nach Anspruch 1, **dadurch gekennzeichnet, daß** das Photodiodenarray (1) auf einem ersten Schaltungsträger angeordnet ist, und daß der Mikroprozessor (2) auf einem zweiten Schaltungsträger angeordnet ist, welche Schaltungsträger miteinander elektrisch leitend verbundene Leiterbahnen aufweisen.

3. Elektrische Schaltungsanordnung nach Anspruch 1 oder 2, **dadurch gekennzeichnet, daß** der erste Prüfwiderstand (R1) und der zweite Prüfwiderstand (R2) wertmäßig gleich sind.

4. Verfahren zur Überprüfung der Intaktheit eines Photodiodenarrays (1) sowie einer Leitungsverbindung (3) zwischen dem Photodiodenarray (1) und einem räumlich von diesem abgesetzten Mikroprozessor (2) in einer elektrischen Schaltungsanordnung nach einem der vorhergehenden Ansprüche, **dadurch gekennzeichnet, daß** der Port-Ausgang (2") des Mikroprozessors (2) einmal mit Massepotential und einmal mit Versorgungsspannungspotential verbunden wird, und jeweils über den Analog-Digital-Wandler-Eingang (2') des Mikroprozessors (2) die betreffenden Spannungswerte eingelesen und nach Maßgabe vorgegebener Tabellenwerte ausgewertet werden.

## Claims

1. Electrical circuit arrangement for examining the integrity of a photodiode array (1) and of a line connection (3) between the photodiode array (1) and a microprocessor (2) located remotely from the same and provided for the purpose of analysing the output signal of the same, with the output (1') of the photodiode array (1) being high-resistance in its inactive, intact state and being connected via a defined internal resistance (RM, RV) to ground potential or supply voltage potential, as the case may be, in the event of a fault, **characterised in that** the output (1') of the photodiode array (1) is connected via a closely disposed first testing resistor (R1) to ground potential or to supply voltage potential and that the analogue-digital converter input (2') of the microprocessor (2) provided for receiving the signal is connected via a closely disposed second testing resistance (R2) to a port output (2") of the microprocessor (2) which can be connected either to ground potential or to the supply voltage potential.

2. Electrical circuit arrangement according to Claim 1, **characterised in that** the photodiode array (1) is located on a first circuit carrier, and that the microprocessor (2) is located on a second circuit carrier, with the said circuit carriers showing printed conductors which are interconnected in an electrically conductive manner.

3. Electrical circuit arrangement according to Claim 1 or Claim 2, **characterised in that** the first testing resistance (R1) and the second testing resistance (R2) are of equal values.

4. Process for examining the integrity of a photodiode array (1) and of a cable connection (3) between the photodiode array (1) and a microprocessor (2) located remotely from the same in an electrical circuit arrangement according to any of the preceding claims, **characterised in that** the port output (2") of the microprocessor (2) is connected once to ground potential and once to the supply voltage potential and the relevant voltage values are read in by way of the analogue-digital converter input (2') of the microprocessor (2) in each case and evaluated according to specified tabular values.

## Revendications

1. Circuit électrique de commutation pour vérifier l'intégrité d'un réseau de photodiodes (1) ainsi que d'une ligne de jonction (3) entre le réseau de photodiodes (1) et un microprocesseur (2), prévu, à l'écart dudit réseau, pour l'évaluation du signal de sortie de celui-ci, sachant que la sortie (1') du réseau de photodiodes (1), à l'état intact, inactivé, est à impédance élevée et, en cas de défaut, est mise à la masse, respectivement au potentiel de la tension d'alimentation, par l'intermédiaire d'une résistance interne fixe (RM, RV), **caractérisé en ce que** la sortie (1') du réseau de photodiodes (1) est connectée à la masse ou à la tension d'alimentation par l'intermédiaire d'une première résistance de contrôle (R1), et que l'entrée convertisseur analogique numérique (2') du microprocesseur (2), prévue pour la réception du signal, est reliée, par l'intermédiaire d'une deuxième résistance de contrôle (R2), disposée è proximité de celui-ci, à un port de sortie (2") du microprocesseur (2), qui peut être relié au choix à la masse ou au potentiel de tension d'alimentation.

2. Circuit électrique de commutation selon la revendication 1, **caractérisé en ce que** le réseau de photodiodes (1) est disposé sur un premier support de circuit et que le microprocesseur (2) est disposé sur un deuxième support de circuit, lesdits supports de circuits présentant des pistes conductrices qui sont reliées ensemble à conduction électrique.

3. Circuit électrique de commutation selon revendication 1 ou 2, **caractérisé en ce que** la première résistance de contrôle (R1) et la deuxième résistance de contrôle (R2) sont équivalentes.

4. Procédé de vérification de l'intégrité d'un réseau de photodiodes (1) ainsi que d'une ligne de jonction (3) entre le réseau de photodiodes (1) et un microprocesseur (2), prévu, à l'écart dudit réseau, dans un circuit électrique de commutation selon l'une des revendications précédentes, **caractérisé en ce que** le port de sortie (2 ") du microprocesseur (2) peut être sélectivement relié au potentiel de la masse ou au potentiel de la tension d'alimentation, et que, chaque fois, par l'intermédiaire de l'entrée (2') convertisseur analogique numérique du microprocesseur (2), les valeurs de tension concernées sont lues et évaluées en comparaison avec un tableau de valeurs prédéterminées.
